# EUROPEAN PATENT APPLICATION

(11) **EP 4 783 755 A1**
(43) Date of publication of application: **29.07.2026**
(21) Application number: 24870436.3
(22) Date of filing: 10.09.2024
(51) Int. Cl.: H05K 5/02

(54) **VEHICLE-MOUNTED DEVICE, DISPLAY APPARATUS, AUDIO APPARATUS AND TERMINAL**

(30) Priority: 27.09.2023 CN 202311271205
(71) Applicant: Yinwang Intelligent Technologies Co., Ltd., Shenzhen, Guangdong 518110 (CN)
(72) Inventor: GUO, Yi, Shenzhen, Guangdong 518129 (CN); LI, Wenyuan, Shenzhen, Guangdong 518129 (CN); ZHANG, Zhiyang, Shenzhen, Guangdong 518129 (CN)
(74) Representative: Gill Jennings & Every LLP
(86) International application number: PCT/CN2024/117929
(87) International publication number: WO 2025/066891

(57) **Abstract**

A vehicle-mounted apparatus, a display device, an audio device, and a terminal are provided, and relate to the field of vehicle-mounted device technologies. In this application, the vehicle-mounted apparatus includes a housing and a panel. At least a part of the housing encloses a cavity. The panel is configured to seal the cavity, and the panel is provided with a connection hole. The panel is fixedly mounted on the housing through an energy-absorbing component, the energy-absorbing component includes a bonding layer and a first connection structure, the bonding layer is disposed between the panel and the housing and is configured to bond the panel and the housing, and the first connection structure is configured to be assembled with the connection hole to implement a fastened connection between the panel and the housing. The energy-absorbing component can maintain a tight connection between the panel and the housing, can reduce a risk of a dangerous phenomenon such as deformation, falling-off, or cracking of a component in the vehicle-mounted apparatus when the panel is impacted, significantly improve anti-collision performance of the vehicle-mounted apparatus, and improve personal safety assurance for a user.

## Description

This application claims priority to Chinese Patent Application No. 202311271205.9, filed with the China National Intellectual Property Administration on September 27, 2023 and entitled "VEHICLE-MOUNTED APPARATUS, DISPLAY DEVICE, AUDIO DEVICE, AND TERMINAL", which is incorporated herein by reference in its entirety.

### TECHNICAL FIELD

This application relates to the field of vehicle-mounted device technologies, and in particular, to a vehicle-mounted apparatus, a display device, an audio device, and a terminal.

### BACKGROUND

As people have increasingly higher requirements for vehicle-mounted functions such as comfort, security, and convenience of a mobile terminal (for example, a transportation means like a vehicle, a ship, or an airplane), increasingly more intelligent, digitalized, and networked apparatuses are integrated into the mobile terminal. A vehicle is used as an example. A rear-row liquid crystal display, a rear-row projection device, and an in-vehicle speaker are gradually used in large-, medium-, and small-sized passenger vehicles, business vehicles, and engineering vehicles, to comprehensively improve performance of a cockpit and passenger experience.

However, these intelligent devices also pose a risk to safety of passengers. Because a mobile terminal like a vehicle needs to travel in an external environment, the mobile terminal often encounters scenarios such as acceleration, abrupt braking, collision, and bump. Among casualty accidents caused by vehicle accidents, a cause of many casualty accidents is that a passenger is cut, scratched, or the like by a device that falls off, deforms, or breaks, and a component of the device. Especially, when a vehicle-mounted apparatus is disposed in a front-row seat of a vehicle, if the vehicle encounters collision or abrupt braking, a rear-row passenger may impact the front-row seat at a high speed. In this case, if the vehicle-mounted apparatus disposed in the front-row seat falls off or breaks due to collision, the rear-row passenger may be seriously injured.

Therefore, how to improve anti-collision performance of the vehicle-mounted apparatus is a hot topic being studied by persons skilled in the art.

### SUMMARY

Embodiments of this application provide a vehicle-mounted apparatus, a display device, an audio device, and a terminal, to significantly improve anti-collision performance of the vehicle-mounted apparatus, and improve personal safety assurance for a user.

According to a first aspect, an embodiment of this application provides a vehicle-mounted apparatus. The vehicle-mounted apparatus includes a housing and a panel. At least a part of the housing encloses a cavity. The panel is configured to seal the cavity, and the panel is provided with a connection hole. The panel is fixedly mounted on the housing through an energy-absorbing component, the energy-absorbing component includes a bonding layer and a first connection structure, the bonding layer is disposed between the panel and the housing and is configured to bond the panel and the housing, and the first connection structure is configured to be assembled with the connection hole to implement a fastened connection between the panel and the housing.

Optionally, the vehicle-mounted apparatus may be mounted in a mobile terminal, for example, in a seat of the mobile terminal, or on a top of a cockpit of the mobile terminal.

In some drivable terminals, when the panel disposed on the cavity is impacted, the panel may be dented into the cavity, causing risks such as falling-off, deformation, and cracking, and threatening personal and property safety of a user. However, in this application, the energy-absorbing component is disposed in the vehicle-mounted apparatus, and the energy-absorbing component is configured to fasten the panel, and conduct and disperse impact force on the panel when the panel is impacted.

The energy-absorbing component includes the bonding layer, and bonding interfaces separately formed by the bonding layer between the panel and the housing may provide reaction force when the panel is subject to external force, to reduce a possibility of deformation and falling-off of the panel. In addition, the energy-absorbing component further includes the first connection structure. Assembly between the first connection structure and the connection hole of the panel may implement relative fastening between the panel and a mechanical part, and ensure a tight connection between the panel and the mechanical part, to further reduce a risk like falling-off and cracking of the panel due to large deformation.

When an object impacts the panel or a component other than the panel, when impact force reaches the panel, the impact force is conducted to the housing through the bonding layer and/or the first connection structure, and the like. In this way, the panel is not prone to a risk like deformation, falling-off, or cracking, anti-collision performance of the vehicle-mounted apparatus is significantly improved, and personal safety assurance for a user is improved.

In a possible implementation, the first connection structure may include a dowel, a buckle, and another structure that can implement a fastened connection function. The following uses an example in which the first connection structure is a dowel for description.

In a possible implementation, the first connection structure may be disposed on the housing. In some solutions, the housing includes an integrated middle housing, and the dowel may be integratedly connected to the middle housing. In other words, there is a dowel on the housing (namely, the middle housing). In some solutions, a plurality of components (described in the following) are separately disposed in the housing, and the dowel may be integratedly connected to a part of the components (for example, one of the components) in the housing. In other words, a part of the components included in the housing have a dowel.

In a possible implementation, a body of the housing is configured to enclose the cavity, the housing further has the first connection structure, and the first connection structure of the housing is assembled with a connection hole of the panel, to implement a fastened connection between the housing and the panel. In other words, the housing may be considered as an integrated structure. In this implementation, the housing forms the cavity, and is configured to implement fastening and anti-collision of the panel, and no other mechanical part is introduced, so that an anti-collision requirement can be met with reduced costs.

Optionally, the bonding layer may be disposed between the housing (or the body of the housing) and the panel. Further, when the first connection structure is a dowel, a gap between the dowel and the panel may also be filled with an adhesive material, to further improve assembly stability of the dowel and the connection hole. The adhesive material may also be considered as a bonding layer.

In a possible implementation of the first aspect, the housing includes a middle housing and a mechanical part. The panel is fixedly mounted on the mechanical part through the energy-absorbing component. The first connection structure is disposed on a side that is of the mechanical part and that faces the panel, and the bonding layer is disposed between the panel and the mechanical part.

In other words, in some solutions, the middle housing and the mechanical part are disposed separately. In the foregoing implementation, the housing includes the housing and the mechanical part. The housing is configured to enclose the cavity, and the mechanical part is configured to implement fastening and anti-collision of the panel, to implement decoupling of different functional components. For example, the mechanical part may use a structure with a larger rigidity due to force, to improve stability of an entire mechanism.

Optionally, the mechanical part is located between the middle housing and the panel. When the panel is impacted and impact force in a cavity direction is generated, both the bonding layer and the first connection structure on the mechanical part can fasten the panel. In addition, the mechanical part can further provide support force for the panel, to further improve anti-collision performance of the vehicle-mounted apparatus.

In still another possible implementation of the first aspect, the mechanical part is fastened to the middle housing. When the mechanical part is fastened to the middle housing, stability of an overall structure can be improved.

In still another possible implementation of the first aspect, at least a part of the mechanical part is disposed on a side that is of the panel and that is away from the cavity. In this way, at least a part of the panel may be surrounded by the mechanical part. In some cases, an impact point may be transferred to the mechanical part, to further improve anti-collision performance of the vehicle-mounted apparatus.

For example, when an object impacts the panel, after reaching the panel, impact force is conducted to a component like the mechanical part through the bonding layer, the first connection structure, and the like. This is equivalent to that the mechanical part provides "pulling force" for the panel, so that the panel is not prone to a fortuitous event like deformation, falling-off, or cracking.

In still another possible implementation of the first aspect, the mechanical part includes a bottom plate and a side wall. The side wall is disposed around the bottom plate, the bottom plate is in a ring shape and covers an edge of the panel, the first connection structure is disposed on a side that is of the bottom plate and that faces the panel, and the side wall is annularly disposed on a periphery of the middle housing.

In this implementation, when an impact object impacts the side wall, the panel, or the like of the mechanical part, impact force generated by the impact can be conducted out by the mechanical part, the housing, or the like in time, to improve an anti-collision capability of the vehicle-mounted apparatus.

In still another possible implementation of the first aspect, the vehicle-mounted apparatus further includes a fastened connection structure, and the fastened connection structure is configured to fasten the housing to the seat.

In this implementation, the housing is mounted on the seat and is fastened to the seat through the fastened connection structure. In this way, impact force exerted on the vehicle-mounted apparatus can be quickly conducted to the seat, to further improve an anti-collision capability of the vehicle-mounted apparatus.

In still another possible implementation of the first aspect, the fastened connection structure includes a rotating shaft fastener and a rotating shaft cantilever, where the rotating shaft fastener is fastened to the middle housing; the rotating shaft fastener has a rotating shaft that is disposed protrudingly; the rotating shaft cantilever is provided with a rotating shaft connection hole, and the rotating shaft connection hole is configured to be assembled with the rotating shaft, so that the rotating shaft cantilever rotates around the rotating shaft; and the rotating shaft cantilever includes a second connection structure, and the second connection structure is configured to implement a fastened connection between the rotating shaft cantilever and the seat.

In the foregoing implementation, stability of the vehicle-mounted apparatus when the vehicle-mounted apparatus is subject to external force (for example, in a case of vibration or impact) can be improved by using the rotating shaft cantilever and the rotating shaft. In addition, a structure in which the rotating shaft cantilever is combined with a fastened rotating shaft can further improve stability and an anti-collision capability of the vehicle-mounted apparatus.

In still another possible implementation of the first aspect, one end of the rotating shaft fastener presses against the mechanical part. In this way, acting force conducted to the mechanical part may be directly conducted to the seat through the fastener and the rotating shaft cantilever, and the seat may provide a fastening function and a buffering function for the vehicle-mounted apparatus, to further improve an anti-collision capability of the vehicle-mounted apparatus.

In still another possible implementation of the first aspect, the mechanical part is fastened to the seat. In this way, stability of the overall structure can be improved, acting force conducted to the mechanical part may be directly conducted to the seat through the fastened connection, and the seat may provide a fastening function and a buffering function for the vehicle-mounted apparatus, to further improve an anti-collision capability of the vehicle-mounted apparatus.

In still another possible implementation of the first aspect, the mechanical part is a metal part. The metal may be an alloy, a pure metal, or the like. Because the metal has high rigidity, it is more convenient to fasten the panel and transfer impact force, and an anti-collision capability of the vehicle-mounted apparatus can be further improved.

In still another possible implementation of the first aspect, the seat includes a headrest, and the vehicle-mounted apparatus is disposed on the headrest of the seat.

In still another possible implementation of the first aspect, the seat includes a backrest, and the vehicle-mounted apparatus is disposed on the backrest of the seat.

In still another possible implementation of the first aspect, the seat includes a headrest, a backrest, and a connection part connecting the backrest and the headrest, and the vehicle-mounted apparatus is disposed on the connection part.

Optionally, the headrest and the backrest of the seat may be disposed separately, or may be disposed in an integrated manner.

In still another possible implementation of the first aspect, the panel is disposed on a side that is of the seat and that faces a rear of the mobile terminal. In this way, in the foregoing implementation, a risk of deformation, falling-off, or even cracking of the panel of the vehicle-mounted apparatus due to impact can be reduced, and personal safety of a rear passenger can be ensured.

In still another possible implementation of the first aspect, the housing is provided with a protruding part, the protruding part extends in a direction from the housing to the panel, a top of the protruding part presses against the panel, and the bonding layer is disposed on a side that is of the protruding part and that is away from a center of the panel.

In the foregoing implementation, the protruding part may be disposed to provide support force in a direction away from the impact point for the bonding layer, so that deformation and displacement of the bonding layer 103 are not easily generated. Stability of the overall structure can be improved, and anti-collision performance of the apparatus can be improved. In addition, a phenomenon of degumming due to impact can be avoided, and aesthetics of the vehicle-mounted apparatus can be improved.

In still another possible implementation of the first aspect, the bonding layer includes a flexible component having adhesiveness. The adhesion of the flexible component can enable the bonding layer to form a bonding interface between the housing and the panel, to improve stability. In addition, the flexible component can provide a buffer function when the panel is impacted, to improve anti-collision performance of the apparatus.

Optionally, the bonding layer may be implemented through glue filling. In this case, a surface layer of the glue is adhesive, and a middle part of the glue may be used as a buffer layer to perform a buffering function.

Optionally, the bonding layer may be a double adhesive foam, and the double adhesive foam includes two stacked layers of adhesive and a foam layer located between the two layers of adhesive. The two layers of adhesive may form a bonding interface between the housing and the panel, and the foam layer may perform a buffering function, to improve stability and anti-collision performance of the vehicle-mounted apparatus.

In still another possible implementation of the first aspect, a material of the panel is a fragile material. For example, the panel is a glass panel.

In still another possible implementation of the first aspect, the panel is a composite glass panel, and the composite glass panel includes an inorganic material layer and an organic material layer that are stacked. Optionally, the composite glass panel further includes a thin film, and the thin film covers the inorganic material layer and/or the organic material layer.

In still another possible implementation of the first aspect, a thickness of the inorganic material layer is greater than or equal to 2 millimeters, and a thickness of the organic material layer is greater than or equal to 2 millimeters.

In still another possible implementation of the first aspect, the vehicle-mounted apparatus further includes a signal source, and the signal source is located in the cavity.

The signal source is configured to generate a signal, and the signal is propagated to object space through the cavity and the panel. The signal includes but is not limited to a signal like light, a sound wave, or an electromagnetic wave.

In this implementation, the cavity of the vehicle-mounted apparatus may perform a function of a signal transmission path, to complete a specific function of the vehicle-mounted apparatus. For example, when the signal is light, a plurality of types of optical elements may be disposed in the cavity, and the light may be reflected, refracted, or the like in the optical elements in the cavity. The cavity can provide space for designing a path of the light, so that water discharge and dust-proof effects are implemented, and a service life of the vehicle-mounted apparatus is prolonged. For another example, when the signal is a sound wave, the sound wave is reflected by the cavity a plurality of times, so that a sound playing effect can be improved, and user experience can be improved.

According to a second aspect, an embodiment of this application provides a display device. The display device includes an image generation unit and the vehicle-mounted apparatus according to any one of the implementations of the first aspect. At least a part of a housing of the vehicle-mounted apparatus encloses a cavity. The image generation unit is located in the cavity and is configured to generate a light beam. The light beam is propagated to object space outside the display device through the cavity and a panel in the vehicle-mounted apparatus, to generate a virtual image visible to human eyes.

Optionally, the display device is mounted in a seat of a mobile terminal.

In a possible implementation of the second aspect, the display device further includes an optical element, the optical element is disposed in the cavity, and the optical element is configured to process the light beam.

According to a third aspect, an embodiment of this application provides an audio device. The audio device includes a speaker and the vehicle-mounted apparatus according to any one of the implementations of the first aspect. The audio device is mounted in a seat of a mobile terminal, a housing includes a cavity, the speaker is configured to generate a sound wave, and the sound wave may be propagated to object space outside the audio device.

Optionally, the sound wave may pass through the cavity and a panel in the vehicle-mounted apparatus.

According to a fourth aspect, an embodiment of this application provides a terminal. The terminal includes the vehicle-mounted apparatus according to any one of the implementations of the first aspect, or the terminal includes the display device according to any one of the implementations of the second aspect, or the terminal includes the audio device according to the third aspect.

Optionally, the terminal may be a mobile terminal like a vehicle, a ship, an aircraft, or a logistics robot.

### BRIEF DESCRIPTION OF DRAWINGS

The following briefly describes accompanying drawings used in describing embodiments.
FIG. 1 is a diagram of an application scenario of a vehicle-mounted apparatus according to an embodiment of this application;
FIG. 2 is a diagram of a cross-sectional structure of a vehicle-mounted apparatus according to an embodiment of this application;
FIG. 3 is a diagram of a three-dimensional structure of a vehicle-mounted apparatus according to an embodiment of this application;
FIG. 4 is a diagram of an impact scenario of a vehicle-mounted apparatus according to an embodiment of this application;
FIG. 5 is a diagram of a cross-sectional structure of another vehicle-mounted apparatus according to an embodiment of this application;
FIG. 6 is a diagram of a three-dimensional structure of another vehicle-mounted apparatus according to an embodiment of this application;
FIG. 7 is a diagram of a cross-sectional structure of another vehicle-mounted apparatus according to an embodiment of this application;
FIG. 8 is a diagram of a three-dimensional structure of another vehicle-mounted apparatus according to an embodiment of this application;
FIG. 9 is a diagram of a cross-sectional structure of another vehicle-mounted apparatus according to an embodiment of this application;
FIG. 10 is a diagram of a cross-sectional structure of another vehicle-mounted apparatus according to an embodiment of this application;
FIG. 11 is a diagram of a three-dimensional structure of another vehicle-mounted apparatus according to an embodiment of this application;
FIG. 12 is a diagram of several possible seats with vehicle-mounted apparatuses according to an embodiment of this application;
FIG. 13 is a diagram of an overall structure of a vehicle-mounted apparatus according to an embodiment of this application;
FIG. 14 is a diagram of a structure of a display device according to an embodiment of this application; and
FIG. 15 is a diagram of a structure of an audio device according to an embodiment of this application.

### DESCRIPTION OF EMBODIMENTS

In recent years, increasingly more intelligent, digitalized, and networked devices are integrated into a mobile terminal. These devices bring performance improvement and use experience optimization to the mobile terminal, and also bring more risks to use of the mobile terminal.

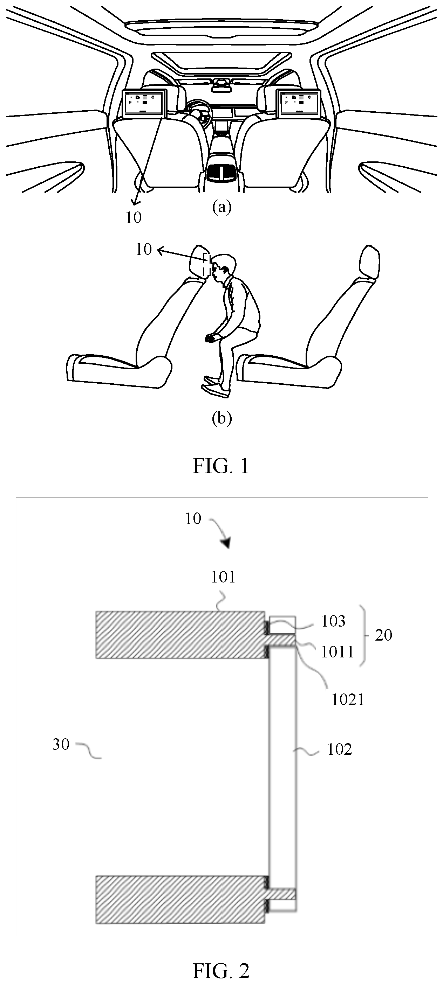

Refer to FIG. 1. FIG. 1 is a diagram of an application scenario of a vehicle-mounted apparatus according to an embodiment of this application. The vehicle-mounted apparatus 10 may be mounted in a seat of a vehicle. As shown in (a) in FIG. 1, the vehicle-mounted apparatus 10 is disposed in the seat of the vehicle and faces a rear of the vehicle. For example, in a process in which a rear-row passenger takes the vehicle, the rear-row passenger may implement one or more entertainment activities such as watching a movie, browsing a web page, playing a video on demand, or playing a game by using the vehicle-mounted apparatus 10 disposed on the front-row seat. However, as shown in (b) in FIG. 1, if the vehicle encounters collision or abrupt braking, the rear-row passenger impacts the front-row seat at a high speed and is very likely to impact the vehicle-mounted apparatus 10, and the vehicle-mounted apparatus 10 is prone to a fortuitous event like deformation, falling-off, or cracking of a component due to impact force caused by the collision, causing serious injury to the rear-row passenger. In particular, the head of the rear-row passenger is very likely to impact the vehicle-mounted apparatus 10. This endangers personal safety of the passenger.

Especially for vehicle-mounted devices with built-in cavity space, such as a display device and a speaker, a dent is generated inward when panels of these devices are impacted by external force. Because there is no component that can bear force in the cavity, the panel of the device is prone to a fortuitous event like deformation, falling-off, or cracking. This threatens personal safety.

In view of this, embodiments of this application provide a vehicle-mounted apparatus, a display device, an audio device, and a terminal, to significantly improve anti-collision performance of the vehicle-mounted apparatus and ensure user safety.

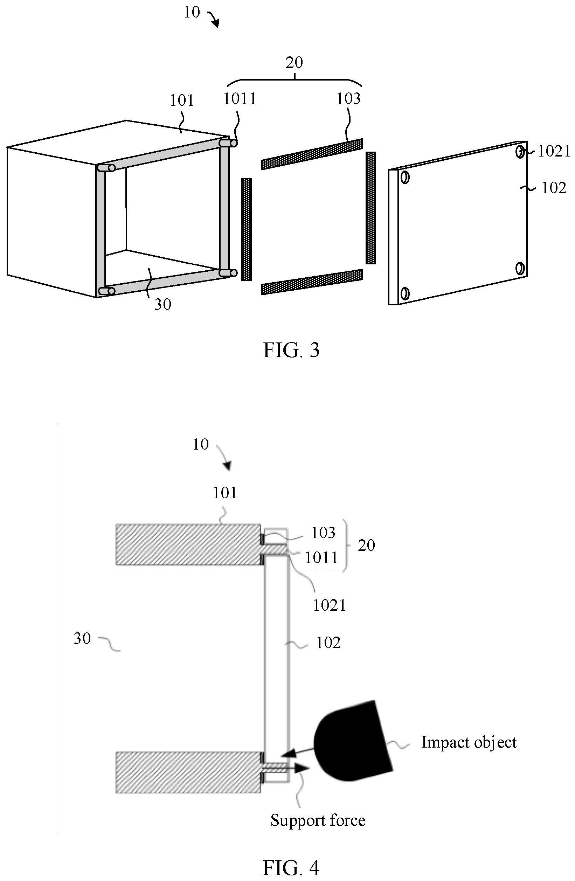

Refer to FIG. 2 and FIG. 3. FIG. 2 is a diagram of a cross-sectional structure of a vehicle-mounted apparatus according to an embodiment of this application. FIG. 3 is a diagram of a three-dimensional structure of a vehicle-mounted apparatus according to an embodiment of this application. The vehicle-mounted apparatus 10 includes a housing 101 and a panel 102.

At least a part of the housing 101 encloses a cavity 30. In other words, the housing 101 may be used as a whole to form the cavity 30, or the housing 101 may include a plurality of parts, and a part of the housing 101 encloses the cavity 30. Optionally, the housing 101 may form a bottom wall and a side wall of the cavity 30, or the housing 101 may be configured to form only a side wall of the cavity 30.

The panel 102 is provided with a connection hole 1021. The connection hole 1021 may be a through hole, a semi-through hole, or the like.

The housing 101 is fixedly assembled with the panel 102 through a first connection structure. The first connection structure may include a dowel, a buckle, and another structure that can implement a fastened connection function. The following uses an example in which the first connection structure is a dowel for description. For example, as shown in FIG. 2, the first connection structure may be a dowel 1011. One end of the dowel 1011 is connected to the housing 101, and the other end is inserted into the connection hole 1021. In this way, a fastened connection between the housing 101 and the panel 102 can be implemented. A bonding layer 103 is further disposed between the housing 101 and the panel 102, and the bonding layer 103 is configured to bond the panel 102 and the housing 101.

In the embodiment shown in FIG. 2, the bonding layer 103 and the dowel 1011 fasten the panel 102 to the housing, and can conduct and disperse impact force on the panel 102 when the panel 102 is impacted. Therefore, the dowel 1011 and the bonding layer 103 may be considered as an energy-absorbing component 20.

Bonding interfaces are formed between the bonding layer 103 and the housing 101 and between the bonding layer 103 and the panel 102, so that the housing 101 and the panel 102 are tightly connected. When the panel 102 is subject to external force, the bonding layer conducts, to the housing 101, the force applied to the panel 102. In addition, assembly between the dowel 1011 disposed on the housing 101 and the connection hole 1021 of the panel 102 can implement a fastened connection between the panel 102 and the housing 101, to further ensure a tight connection between the panel 102 and the housing 101. In the vehicle-mounted apparatus 10 shown in FIG. 2, when an object impacts the panel 102, impact force is conducted to a component like the housing 101 through the bonding layer 103, the dowel 1011, and the like after reaching the panel 102. In this way, the panel 102 is not prone to a risk like deformation, falling-off, or cracking, anti-collision performance of the vehicle-mounted apparatus 10 is significantly improved, and user safety is ensured.

In an embodiment, the first connection structure may be fixedly disposed on the housing 101. The dowel 1011 is used as an example. The dowel 1011 may be disposed on the housing 101. One end of the dowel 1011 may be connected to the housing (the connection herein may include a case in which the dowel 1011 is integrally connected to the housing 101); and the other end is a free end, and is configured to be fixedly assembled with the panel 102. In some solutions, the housing 101 includes an integrated middle housing, and the dowel may be integratedly connected to the middle housing. In other words, there is a dowel 1011 on the housing 101. In some solutions, the housing 101 includes a plurality of components (described in the following) that are separately disposed, and the dowel 1011 may be integratedly connected to a part of the components (for example, one of the components) in the housing 101. In other words, a part of the components included in the housing 101 have a dowel 1011.

In an embodiment, the energy-absorbing component 20 is disposed at an edge of the panel 102, as shown in FIG. 2.

In an embodiment, the panel 102 is configured to seal the cavity 30. Sealing herein may be full sealing, or may be semi-sealing. In this embodiment, because the cavity 30 exists in the housing 101, when the panel 102 is impacted by external force, the panel 102 is recessed into the cavity in the housing 101. The energy-absorbing component 20 may fasten the panel 102 to resist the impact force, to improve anti-collision performance of an overall structure.

In an embodiment, the panel 102 includes a glass panel. Optionally, a thickness of the panel 102 is greater than or equal to 4 millimeters (mm). For example, the thickness of the panel is 4.1 mm. When the thickness of the panel is greater than 4 mm, the panel 102 may have greater stress when being subject to an impact object, to resist deformation caused by the impact, so that the vehicle-mounted apparatus can have stronger anti-collision performance.

In some embodiments, the panel 102 includes a composite glass panel, and there are at least two layers of stacked composite glass panels. In a possible implementation, the panel 102 includes an inorganic material layer and an organic material layer that are stacked. In some cases, a thickness of the inorganic material layer is greater than or equal to 2 millimeters, and a thickness of the organic material layer is greater than or equal to 2 millimeters.

Optionally, there may be a plurality of connection holes 1021 disposed on the panel 102. Correspondingly, there are a plurality of dowels 1011 that are on the housing 101 and that are assembled with the connection holes 1021. The plurality of connection holes 1021 may be disposed on a part that is of the panel 102 and that is close to the edge. However, in some solutions, the connection hole 1021 may be disposed around the edge of the panel 102. With reference to FIG. 3, when the panel 102 is a polygon, the connection hole 1021 may be disposed at a corner that is of the panel and that is close to the polygon. This is more conducive to fastening the panel 102 in combination with the energy-absorbing component 20.

In an embodiment, the bonding layer 103 includes a flexible component having adhesiveness. In some solutions, the bonding layer 103 includes an adhesive layer and a buffer layer. The adhesive layer has adhesiveness, and can implement a connection between objects. The buffer layer is configured to implement buffering to improve stability of the overall structure. For example, the bonding layer 103 may be implemented through glue. In this case, a surface layer of the glue is adhesive, and a middle part of the glue may be used as a buffer layer to perform a buffering function. For another example, the bonding layer 103 may be a double adhesive foam, and the double adhesive foam includes two stacked layers of adhesive and a foam layer located between the two layers of adhesive. The two layers of adhesive may form a bonding interface between the housing and the panel, and the foam layer may perform a buffering function, to improve stability and anti-collision performance of the vehicle-mounted apparatus.

Optionally, as shown in FIG. 3, the bonding layer 103 may include a plurality of parts that are disposed separately. Certainly, this application is also applicable to the bonding layer 103 in an integrated design.

Optionally, the bonding layer 103 may be disposed between the housing 101 (or a body of the housing) and the panel. Further, a gap between the dowel 1011 and the panel 102 may also be filled with an adhesive material, to further improve assembly stability of the dowel and the connection hole. The adhesive material may also be considered as the bonding layer 103.

Alternatively, the dowel 1011 described in embodiments of this application may be replaced with another connection structure that can fasten the panel 102 to the housing 101.

The following describes a possible design of the housing 101.

In an embodiment, with reference to FIG. 2 and FIG. 3, the housing 101 is of an integrated structure, and the body of the housing 101 is configured to enclose the cavity 30. The housing 101 further has the dowel 1011, and the dowel 1011 of the housing 101 is assembled with the connection hole 1021 of the panel 102, to implement a fastened connection between the housing 101 and the panel 102. In the structure shown in FIG. 2, when impact force reaches the panel 102, the force exerted on the panel 102 may be conducted to the housing 101 by the energy-absorbing component 20, so that the connection between the panel 102 and the housing 101 is more stable, and an anti-collision capability of the overall structure is improved. In conclusion, the housing 101 forms the cavity, and is configured to stabilize and fasten the panel 102 without introducing another mechanical part, so that an anti-collision requirement can be met at reduced costs.

Refer to FIG. 4. Especially when an impact point of the impact object on the vehicle-mounted apparatus is located near a location that is on the panel and that is close to the energy-absorbing component, the housing 101 can further provide support force for the panel, to further improve anti-collision performance of the vehicle-mounted apparatus. The scenario shown in FIG. 1 is used as an example. When the vehicle-mounted apparatus is disposed in a part that is of the vehicle and that is close to a roof of the vehicle, for example, at a location like a headrest of a seat or an upper part of a vehicle body, impact of an object on the vehicle-mounted apparatus is usually located in a lower part of the vehicle-mounted apparatus. Therefore, the vehicle-mounted apparatus shown in FIG. 4 is used at these locations, so that an anti-collision capability of the vehicle-mounted apparatus can be improved at low costs.

Certainly, the embodiment shown in FIG. 3 is merely an example. The following continues to describe possible designs of a location and a function of the housing 101.

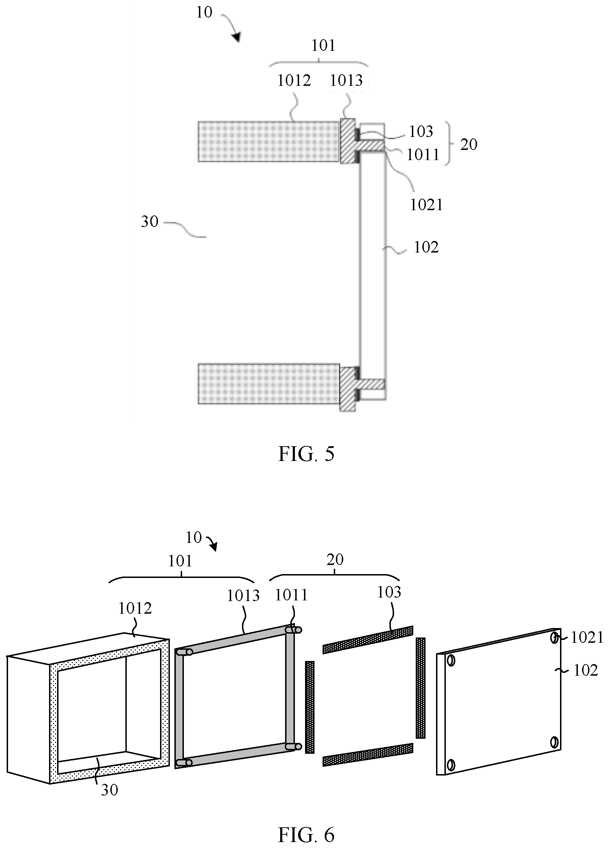

In an embodiment, refer to FIG. 5 and FIG. 6. The housing 101 includes a middle housing 1012 and a mechanical part 1013. The panel 102 is fixedly mounted on the mechanical part 1013 through the energy-absorbing component 20. The dowel 1011 is disposed on a side that is of the mechanical part 1013 and that faces the panel 102, and the bonding layer 103 is disposed between the panel 102 and the mechanical part 1013. For detailed descriptions of some components, refer to the foregoing descriptions.

In other words, the mechanical part 1013 and the middle housing 1012 are disposed separately, the middle housing 1012 encloses the cavity 30, and the mechanical part 1013 is configured to implement fastening and anti-collision of the panel, to implement decoupling of different functional components. For example, the mechanical part may use a material (for example, a metal material) with higher rigidity or a more stable structure (for example, an arch) due to force, to improve stability of an overall mechanism. The middle housing 1012 is mainly configured to form the cavity, and therefore may use another material. For example, a material that is more soundproof, more heatproof, or lighter may be used, for example, a plastic material. It can be easily learned that when the impact force reaches the panel 102, the force exerted on the panel 102 may be conducted by the energy-absorbing component 20 to the mechanical part 1013, and may be further conducted to another apparatus through the mechanical part 1013, so that mounting of the panel 102 is more stable, and the anti-collision capability of the vehicle-mounted apparatus 10 is improved.

In the structures shown in FIG. 5 and FIG. 6, the mechanical part 1013 is located between the middle housing 1012 and the panel 102. When the panel 102 is impacted and impact force towards the cavity is generated, both the bonding layer 103 and the dowel 1011 on the mechanical part 1013 can fasten the panel. In addition, the mechanical part 1013 can further provide support force for the panel 102, to further improve anti-collision performance of the vehicle-mounted apparatus. Especially when the impact point is located near the location that is on the panel and that is close to the energy-absorbing component, the panel 102 is not easily deformed, and the mechanical part 1013 may firmly support the panel 102, so that the overall structure is stable and has excellent anti-collision performance.

For example, the middle housing 1012 may press against the mechanical part 1013. In this way, the mechanical part 1013 may conduct the impact force or a part of the impact force to the middle housing 1012, to transfer and disperse the force, and improve stability of the overall structure.

In an embodiment, when the mechanical part 1013 and the middle housing 1012 are disposed separately, the mechanical part 1013 may be fastened to the middle housing 1012. In this way, stability of the overall structure formed by the energy-absorbing component, the panel, and the housing can be further improved, and anti-collision performance can be further improved. In some possible implementations, the fastened connection may be implemented by using one or more apparatuses such as a dowel, a screw, and a buckle.

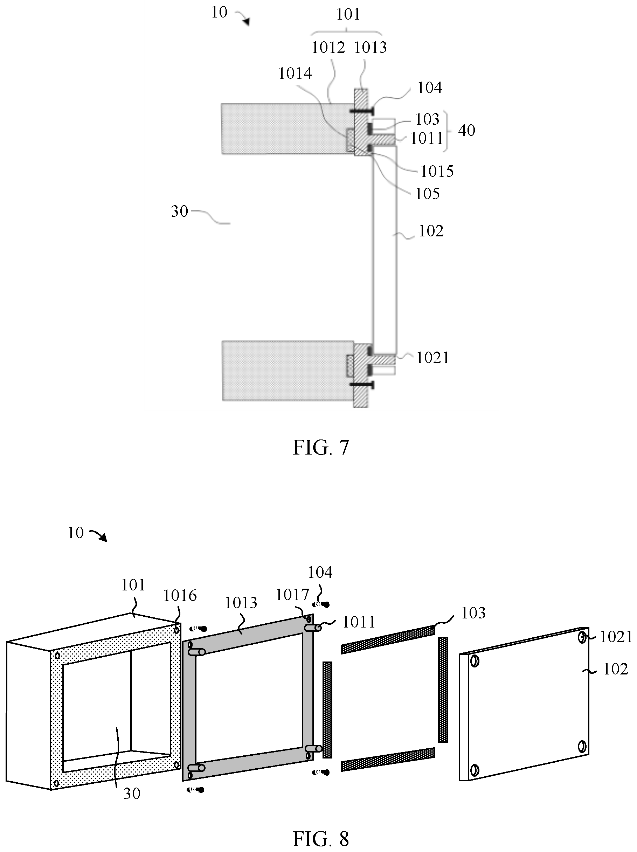

Refer to FIG. 7. The mechanical part 1013 may be fastened to the middle housing 1012 through a tapping screw 104. Refer to FIG. 8, the mechanical part 1013 is provided with a through hole 1017, the middle housing 1012 is provided with a blind hole 1016, and the tapping screw 104 may penetrate the through hole 1017 and be inserted into the blind hole 1016. In this way, the mechanical part 1013 is fastened to the middle housing 1012.

In some embodiments, refer to FIG. 7. A groove 1014 is further disposed on a side that is of the middle housing 1012 and that is close to the panel 102, and a flexible material 105 may be disposed in the groove 1014. Generally, in a natural case, a thickness of the flexible material 105 is higher than a depth of the groove 1014, one end of the flexible material 105 presses against a bottom surface of the groove 1014, and the other end presses against the mechanical part 1013. In this way, a dustproof or soundproof design of the vehicle-mounted apparatus can be implemented, and a service life and quality of service of the apparatus can be improved. For example, if the flexible material 105 is disposed, dust can be prevented from entering the cavity 30 through a gap between the middle housing 1012 and the mechanical part 1013. In addition, the flexible material 105 may also play a buffer role, to further improve stability of the overall structure. Optionally, the flexible material may be, for example, a foam (for example, a sponge).

In some embodiments, refer to FIG. 7. The mechanical part 1013 is provided with a protruding part 1015, the protruding part 1015 extends in a direction from the mechanical part 1013 to the panel 102, and a top of the protruding part 1015 presses against the panel 102, and the bonding layer 103 is disposed on a side that is of the protruding part 1015 and that is away from a center of the panel 102. In a possible case, if the central part of the panel 102 is impacted, because the panel 102 deforms into the cavity 30 when being impacted, the bonding layer 103 is subject to pulling force in a direction towards the impact point. When the pulling force is applied to the bonding layer 103, the bonding layer tends to move toward the impact point. The protruding part 1015 may be disposed to provide support force for the bonding layer 103 in a direction away from the impact point, so that the bonding layer 103 is not prone to deformation and displacement. As a result, stability of the overall structure can be further improved, and anti-collision performance of the apparatus can be improved. In addition, the bonding layer 103 is not prone to degumming, and overall aesthetics is improved.

Optionally, when the housing 101 is in an integrated design, the protruding part 1015 may alternatively be a protruding part that is of the housing 101 and that is in a direction toward the panel 102. For related descriptions, refer to the descriptions of the protruding part 1015 in FIG. 7.

It should be understood that FIG. 2 to FIG. 8 are described by using an example in which the mechanical part 1013 is disposed on a side that is of the panel 102 and that is close to the cavity 30. In an actual implementation process, a location relationship between the mechanical part 1013 and the panel 102 may have another design.

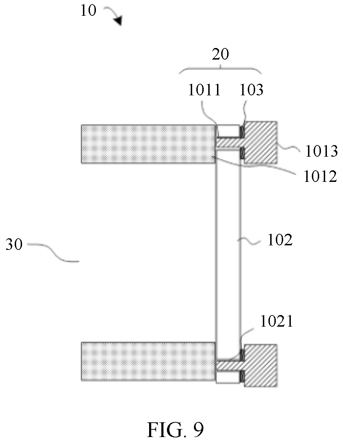

In still another embodiment, the housing 101 includes a middle housing 1012 and a mechanical part 1013, and at least a part of the mechanical part 1013 is disposed on a side that is of the panel 102 and that is away from the cavity 30. Refer to FIG. 9. The housing 101 includes the middle housing 101 and the mechanical part 1013. The panel 102 is fixedly mounted on the mechanical part 1013 through the energy-absorbing component 20. The dowel 1011 is disposed on a side that is of the mechanical part 1013 and that faces the panel 102, and the bonding layer 103 is disposed between the panel 102 and the mechanical part 1013. Because the mechanical part 1013 is disposed on a side that is of the panel 102 and that is away from the cavity 30, when an object impacts the panel 102, impact force is conducted to a component like the mechanical part 1013 through the bonding layer 103, the dowel 1011, and the like after reaching the panel 102. This is equivalent to that the mechanical part 1013 provides "pulling force" for the panel, so that the panel 102 is not prone to a risk like deformation, falling-off, or cracking, anti-collision performance of the vehicle-mounted apparatus 10 is improved, and user safety is ensured.

With reference to FIG. 9 and the foregoing embodiments, in a possible implementation, the middle housing 1012 encloses the cavity 30. In this case, the middle housing 1012 may press against the panel 102, to provide support force for the panel 102 when the panel 102 is subject to external force, to further fasten the panel 102 to prevent the panel 102 from falling off and deforming, and significantly improve an anti-collision capability of the overall structure.

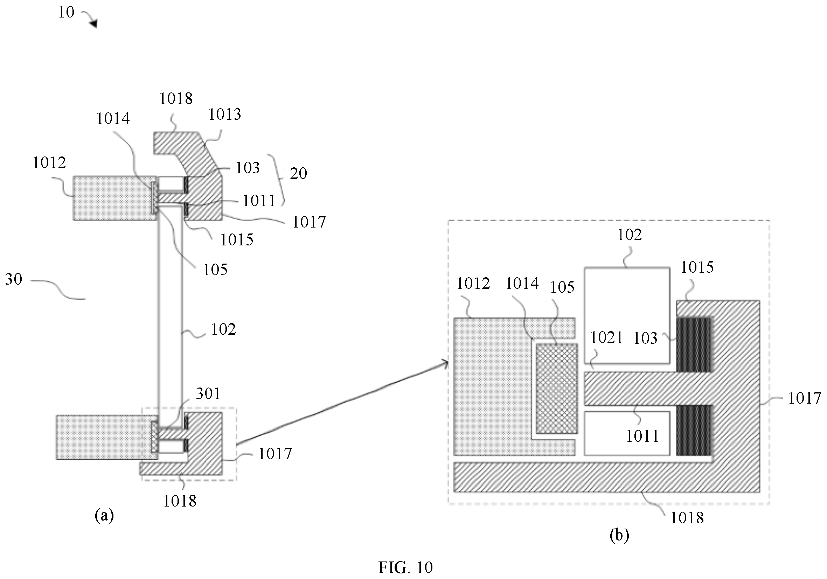

In another embodiment, refer to (a) in FIG. 10 and (b) in FIG. 10, where (b) in FIG. 10 is an enlarged diagram of a structure in (a) in FIG. 10. The mechanical part 1013 includes a bottom plate 1017 and a side wall 1018. The side wall 1018 of the mechanical part 1013 is disposed around the bottom plate 1017, the bottom plate 1017 covers an edge of the panel 102 in a ring shape, a dowel 1011 is disposed on a side that is of the bottom plate 1017 and that faces the panel 102, and the side wall 1018 is annularly disposed on a periphery of the middle housing 1012. In this way, when an impact object impacts the side wall, the panel, or the like of the mechanical part, impact force generated by the impact can be conducted out by the mechanical part, the housing, or the like in time, to improve an anti-collision capability of the overall structure.

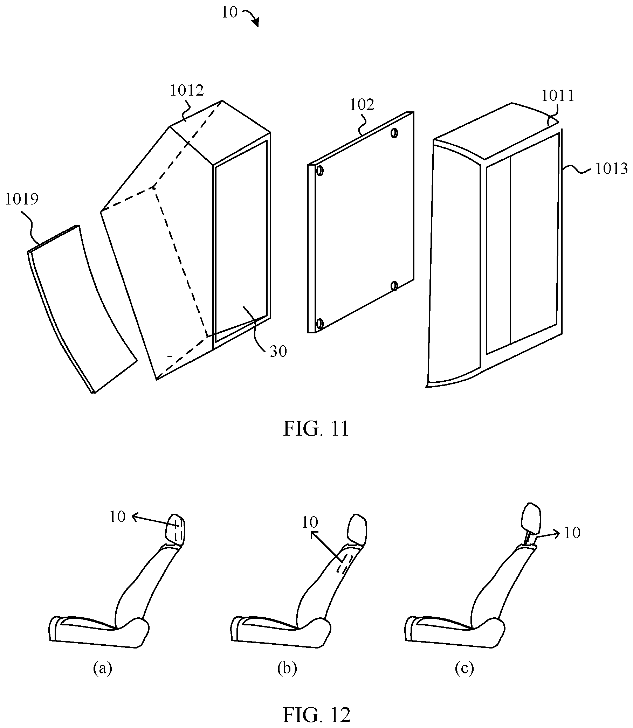

Refer to FIG. 11. FIG. 11 is a diagram of a three-dimensional structure of another vehicle-mounted apparatus 10 according to an embodiment of this application. The vehicle-mounted apparatus 10 includes a middle housing 1012, a mechanical part 1013, a rear housing 1019, and a panel 102. The middle housing 1012 and the rear housing 1019 encloses a cavity 30. The panel 102 covers the cavity 30, and is configured to seal the cavity 30. The panel 102 is fixedly mounted on the mechanical part 1013 through an energy-absorbing component (not shown in FIG. 11). The mechanical part 1013 further includes a side wall disposed around a periphery of the middle housing 1012. When an impact object impacts the side wall, the panel, or the like of the mechanical part, impact force generated by the impact can be conducted out by the mechanical part, the housing, or the like in time, to improve an anti-collision capability of the overall structure.

In another embodiment, still refer to FIG. 10. A groove 1014 is further disposed on a side that is of the middle housing 1012 and that is close to the panel 102, and a flexible material 105 may be disposed in the groove 1014. In a natural case, a thickness of the flexible material 105 is greater than a depth of the groove. Further, a location of the groove 1014 directly faces a location of the connection hole 1021 in the panel 102, and an opening size of the groove 1014 is greater than a size of the connection hole 1021. It may be understood that, due to a design of the connection hole, external dust may enter the cavity 30 through the connection hole. The groove 1014 is disposed, and the flexible material 105 is disposed in the groove 1014, so that a dustproof design or a soundproof design can be implemented, and a service life and quality of service of the apparatus are improved. In addition, the flexible material 105 may play a buffer role, to further improve stability of the overall structure. Optionally, the flexible material may be, for example, a foam (for example, a sponge).

In an embodiment, the mechanical part 1013 is a metal part. For example, a material of the mechanical part 1013 may be pure metal, alloy, or a combination of pure metal and alloy. Optionally, the mechanical part may be made of an integrated material, or may include a plurality of parts that are disposed separately.

In some cases, the vehicle-mounted apparatus 10 is mounted in a seat of a mobile terminal. The mobile terminal includes but is not limited to a terminal such as a vehicle, a logistics robot, an airplane, or a ship. This application is described by using an example in which the mobile terminal is a vehicle. The apparatus mounted on the vehicle includes but is not limited to a projection device, a speaker, or the like.

The following describes a possible mounting manner of the vehicle-mounted apparatus 10 and the mobile terminal. Refer to FIG. 12. FIG. 12 is a diagram of several possible seats with vehicle-mounted apparatuses according to an embodiment of this application.

In an embodiment, refer to (a) in FIG. 12. A seat includes a headrest, and a vehicle-mounted apparatus 10 is disposed on the headrest of the seat. In a possible implementation, in the headrest, an impacting object is more likely to impact an edge of the vehicle-mounted apparatus 10. Therefore, when vehicle-mounted apparatus 10 is disposed on the headrest of the seat, the structure shown in FIG. 3 and FIG. 4 may be used for implementation, so that anti-collision performance that meets a user requirement is implemented at optimal costs.

In an embodiment, refer to (b) in FIG. 12. A seat includes a headrest, and a vehicle-mounted apparatus 10 is disposed on a backrest of the seat.

Optionally, the headrest and the backrest of the seat may be disposed separately, or may be disposed in an integrated manner.

In an embodiment, refer to (c) in FIG. 12. A seat includes a headrest, a backrest, and a connection part connecting the backrest and the headrest, and a vehicle-mounted apparatus 10 is disposed on the connection part.

In some cases, the vehicle-mounted apparatus 10 may be fixedly assembled with the seat. The following describes several possible implementations of fixed assembly.

In an embodiment, the vehicle-mounted apparatus 10 includes a housing 101, and the housing 101 is fastened to the seat. The following describes two possible connection manners by using examples.

Example 1: The vehicle-mounted apparatus includes a mechanical part 1013, and the mechanical part 1013 is fastened to the seat. In this way, stability of the overall structure can be improved, acting force conducted to the mechanical part may be directly conducted to the seat through the fastened connection, and the seat may provide a fastening function and a buffering function for the vehicle-mounted apparatus, to further improve an anti-collision capability of the vehicle-mounted apparatus.

For example, the mechanical part 1013 may be fixedly assembled with the seat by using a buckle, a screw, a dowel, or the like. In some solutions, when the vehicle-mounted apparatus 10 is disposed in the headrest of the seat, the mechanical part 1013 is fastened to the housing of the headrest.

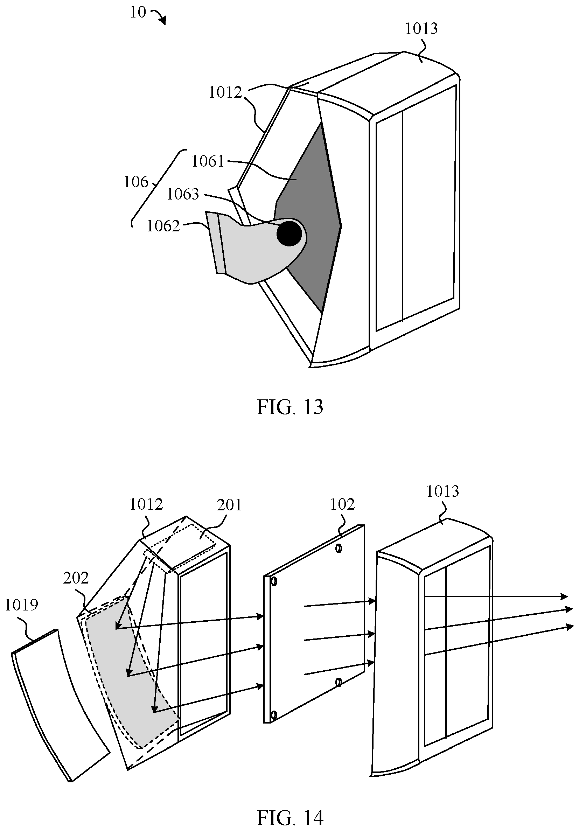

Example 2: The vehicle-mounted apparatus 10 further includes a fastened connection structure 106, and the fastened connection structure 106 is configured to fasten the housing 101 to the seat. Refer to FIG. 13. FIG. 13 is a diagram of an overall structure of a vehicle-mounted apparatus according to an embodiment of this application. The fastened connection structure 106 includes a rotating shaft fastener 1061 and a rotating shaft cantilever 1062. The rotating shaft fastener 1061 is fastened to the middle housing 1012. The rotating shaft fastener 1061 has a rotating shaft 1063 that is disposed protrudingly. The rotating shaft cantilever 1062 is provided with a rotating shaft connection hole (not shown in the figure), and the rotating shaft connection hole is configured to be assembled with the rotating shaft 1063, so that the rotating shaft cantilever 1062 rotates around the rotating shaft 1063. Further, the rotating shaft cantilever 1062 includes a second connection structure, and the second connection structure is configured to implement a fastened connection between the rotating shaft cantilever 1062 and the seat. For example, a through hole is further disposed on the rotating shaft cantilever 1062, and a screw, a dowel, or the like may penetrate the through hole and be assembled with the seat, to implement a fastened connection between the rotating shaft cantilever 1062 and the seat. Alternatively, a buckle component is disposed on the rotating shaft cantilever, and a connection component coupled to the buckle component is disposed on the seat, so that a fastened connection between the rotating shaft cantilever 1062 and the seat can be implemented by assembling the buckle component and the connection component.

In the foregoing implementation, stability of the vehicle-mounted apparatus when the vehicle-mounted apparatus is subject to external force (for example, in a case of vibration or impact) can be improved as impact force can be quickly transferred to the seat by using the rotating shaft cantilever and the rotating shaft. In addition, a structure in which the rotating shaft cantilever is combined with a fastened rotating shaft can further improve stability and an anti-collision capability of the vehicle-mounted apparatus.

It should be understood that the foregoing two examples may alternatively be combined. For example, the mechanical part 1013 is fastened to the seat, or the mechanical part 1013 is fastened to the seat through the fastened connection structure 106 disposed on the middle housing 1012.

Optionally, one end of the rotating shaft fastener 1061 may be further connected to the mechanical part 1013, so that the impact force can be conducted to the rotating shaft fastener 1061 through the mechanical part 1013 and further conducted to the seat through the rotating shaft cantilever 1062. The connection herein may include a connection manner like a fastened connection or a butt joint connection.

In some cases, the vehicle-mounted apparatus 10 may further include a signal source, and the signal source is located in the cavity. The signal source is configured to generate a signal, and the signal is propagated to object space through the cavity and the panel. The signal includes but is not limited to a signal like light, a sound wave, or an electromagnetic wave. It can be easily learned that the cavity of the vehicle-mounted apparatus may perform a function of a signal transmission path, to complete a specific function of the vehicle-mounted apparatus. For example, when the signal is light, a plurality of types of optical elements may be disposed in the cavity, and the light may be reflected, refracted, or the like in the optical elements in the cavity. The cavity can provide space for designing a path of the light, so that water discharge and dust-proof effects are implemented, and a service life of the vehicle-mounted apparatus is prolonged. For another example, when the signal is a sound wave, the sound wave is reflected by the cavity a plurality of times, so that a sound playing effect can be improved, and user experience can be improved.

For example, the following describes some possible applications of the vehicle-mounted apparatus by using a display device and an audio device as examples.

Refer to FIG. 14. FIG. 14 is a diagram of a structure of a display device according to an embodiment of this application. The display device includes an image generation unit 201 and the foregoing vehicle-mounted apparatus. At least a part of a housing of the vehicle-mounted apparatus encloses a cavity. For example, the vehicle-mounted apparatus shown in FIG. 11 is used as an example. The vehicle-mounted apparatus includes a middle housing 1012, a mechanical part 1013, a panel 102, and a rear housing 1019. The middle housing 1012 and the rear housing 1019 encloses a cavity.

The image generation unit 201 is located in the cavity and is configured to generate a light beam. Refer to FIG. 14. The light beam is propagated to object space outside the display device through the cavity and the panel in the vehicle-mounted apparatus. Further, the transmission may be used to generate a virtual image visible to human eyes.

Optionally, the display device is mounted in a mobile terminal, for example, mounted in a seat of the mobile terminal.

In some possible implementations, the display device further includes an optical element, the optical element is disposed in the cavity, and the optical element is configured to process the light beam. The processing herein includes propagation and a change of a feature of a light beam in a propagation process. Propagation may include one or more of a propagation process such as transmission, refraction, reflection, or the like. A change of a feature of a light beam includes one or more of a change of an optical path of the light beam (for example, refraction or reflection), a change of a polarization direction of light included in an emitted light beam, a change in wavelength distribution (for example, filtering), or the like.

As shown in FIG. 14, the display device may further include a curved mirror 202, and the curved mirror may reflect the light beam emitted by the image generation unit 201.

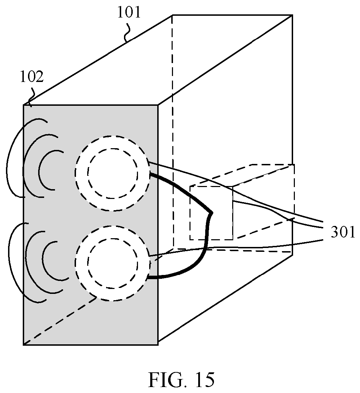

Refer to FIG. 15. FIG. 15 is a diagram of a structure of an audio device according to an embodiment of this application. The audio device includes a speaker 301 and the foregoing vehicle-mounted apparatus. The housing 101 in the vehicle-mounted apparatus encloses a cavity, and the panel 102 covers the cavity. The speaker 301 is configured to generate a sound wave, and the sound wave may be propagated to object space outside the audio device.

Optionally, the sound wave may pass through the cavity and the panel 102.

Optionally, the audio device is mounted in a mobile terminal, for example, mounted in a seat of the mobile terminal.

An embodiment of this application further provides a terminal. The terminal includes the foregoing vehicle-mounted apparatus, or the terminal includes the foregoing display device, or the terminal includes the foregoing audio device.

Optionally, the terminal may be a mobile terminal like a vehicle, a ship, an aircraft, or a logistics robot.

In descriptions of this application, orientation or position relationships indicated by terms "center", "above", "below", "vertical", "horizontal", "inner", "outer", and the like are orientation or position relationships based on the accompanying drawings, and are only intended to facilitate and simplify the description of this application, but are not intended to indicate or imply that an apparatus or an element needs to have a specific orientation and be constructed and operated in a specific orientation, and therefore cannot be understood as a limitation on this application.

In descriptions of this application, unless otherwise explicitly specified and limited, the term "connection" should be understood in a broad sense. For example, the term "connection" may be a fastened connection, a detachable connection, a butt joint connection, or an integrated connection. Contacted connection may be a direct electrical connection, or may be an indirect electrical connection through an intermediate medium. A person of ordinary skill in the art may interpret specific meanings of the foregoing terms in this application according to specific cases.

In embodiments of this application, "end" in terms such as "one end", "the other end", "terminal end", "free end", "upper end", "lower end", and "connecting end" is not limited to an end, an endpoint, or an end face, but also includes a part of an end, an endpoint, or an end face that extends an axial distance and/or a radial distance on an apparatus or element to which the end, the endpoint, or the end face belongs.

In embodiments of this application, words such as "example" or "for example" are used to give an example, an illustration, or a description. Any embodiment or design scheme described as an "example" or "for example" in this application should not be explained as being more preferred or having more advantages than another embodiment or design scheme. Exactly, use of the term such as "example" or "for example" is intended to present a related concept in a specific manner.

In embodiments of this application, "at least one" means one or more, and "a plurality of" means two or more. "At least one of the following items (pieces)" or a similar expression thereof refers to any combination of these items, including any combination of singular items (pieces) or plural items (pieces). For example, at least one of a, b, or c may indicate: a, b, c, (a and b), (a and c), (b and c), or (a, b, and c), where a, b, and c may be singular or plural. The term "and/or" describes an association between associated objects, and indicates that three relationships may exist. For example, A and/or B may indicate the following three cases: Only A exists, both A and B exist, and only B exists, where A and B may be singular or plural. The character "/" generally indicates an "or" relationship between the associated objects.

## Claims

1. A vehicle-mounted apparatus, wherein the vehicle-mounted apparatus comprises a housing and a panel;
the vehicle-mounted apparatus is mounted in a seat of a mobile terminal;
at least a part of the housing encloses a cavity;
the panel is configured to seal the cavity, and the panel is provided with a connection hole; and
the panel is fixedly mounted on the housing through an energy-absorbing component, the energy-absorbing component comprises a bonding layer and a first connection structure, the bonding layer is disposed between the panel and the housing and is configured to bond the panel and the housing, and the first connection structure is configured to be assembled with the connection hole to implement a fastened connection between the panel and the housing.

2. The vehicle-mounted apparatus according to claim 1, wherein the first connection structure comprises a dowel.

3. The vehicle-mounted apparatus according to claim 1 or 2, wherein the housing comprises a middle housing and a mechanical part, and the mechanical part is located between the middle housing and the panel;
the panel is fixedly mounted on the mechanical part through the energy-absorbing component; and
the first connection structure is disposed on a side that is of the mechanical part and that faces the panel, and the bonding layer is disposed between the panel and the mechanical part.

4. The vehicle-mounted apparatus according to claim 3, wherein the mechanical part and the middle housing are disposed separately, and the mechanical part is fastened to the middle housing.

5. The vehicle-mounted apparatus according to claim 1 or 2, wherein the housing comprises a middle housing and a mechanical part, and the middle housing encloses a cavity;
at least a part of the mechanical part is disposed on a side that is of the panel and that is away from the cavity; and
the panel is fixedly mounted on the mechanical part through the energy-absorbing component, the first connection structure is disposed on a side that is of the mechanical part and that faces the panel, and the bonding layer is disposed between the panel and the mechanical part.

6. The vehicle-mounted apparatus according to claim 5, wherein the mechanical part comprises a bottom plate and a side wall; and
the side wall is disposed around the bottom plate, the bottom plate is in a ring shape and covers an edge of the panel, the first connection structure is disposed on a side that is of the bottom plate and that faces the panel, and the side wall is annularly disposed on a periphery of the middle housing.

7. The vehicle-mounted apparatus according to any one of claims 3 to 6, wherein the vehicle-mounted apparatus further comprises a fastened connection structure, and the fastened connection structure is configured to fasten the housing to the seat.

8. The vehicle-mounted apparatus according to claim 7, wherein the fastened connection structure comprises a rotating shaft fastener and a rotating shaft cantilever, wherein
the rotating shaft fastener is fastened to the middle housing;
the rotating shaft fastener has a rotating shaft that is disposed protrudingly;
the rotating shaft cantilever is provided with a rotating shaft connection hole, and the rotating shaft connection hole is configured to be assembled with the rotating shaft, so that the rotating shaft cantilever rotates around the rotating shaft; and
the rotating shaft cantilever comprises a second connection structure, and the second connection structure is configured to implement a fastened connection between the rotating shaft cantilever and the seat.

9. The vehicle-mounted apparatus according to claim 8, wherein one end of the rotating shaft fastener presses against the mechanical part.

10. The vehicle-mounted apparatus according to any one of claims 3 to 9, wherein the mechanical part is fastened to the seat.

11. The vehicle-mounted apparatus according to any one of claims 3 to 10, wherein the mechanical part is a metal part.

12. The vehicle-mounted apparatus according to any one of claims 1 to 11, wherein the seat comprises a headrest and a backrest that are disposed separately, and the vehicle-mounted apparatus is disposed on the headrest of the seat, or is disposed on the backrest of the seat; or
the seat further comprises a connection part connecting the seat and a headrest, and the vehicle-mounted apparatus is disposed on the connection part.

13. The vehicle-mounted apparatus according to claim 12, wherein the panel is disposed on a side that is of the seat and that faces a rear of the mobile terminal.

14. The vehicle-mounted apparatus according to any one of claims 1 to 13, wherein the housing is provided with a protruding part, the protruding part extends in a direction from the housing to the panel, a top of the protruding part presses against the panel, and the bonding layer is disposed on a side that is of the protruding part and that is away from a center of the panel.

15. The vehicle-mounted apparatus according to any one of claims 1 to 14, wherein the bonding layer comprises a flexible component having adhesiveness.

16. The vehicle-mounted apparatus according to any one of claims 1 to 15, wherein the panel is a glass panel.

17. The vehicle-mounted apparatus according to claim 16, wherein the panel is a composite glass panel, and the composite glass panel comprises an inorganic material layer and an organic material layer that are stacked.

18. The vehicle-mounted apparatus according to claim 17, wherein a thickness of the inorganic material layer is greater than or equal to 2 millimeters, and a thickness of the organic material layer is greater than or equal to 2 millimeters.

19. The vehicle-mounted apparatus according to any one of claims 1 to 18, wherein the vehicle-mounted apparatus further comprises a signal source, and the signal source is located in the cavity; and
the signal source is configured to generate a signal, and the signal is propagated to object space through the cavity and the panel.

20. A display device, wherein the display device comprises an image generation unit and the vehicle-mounted apparatus according to any one of claims 1 to 18;
the display device is mounted in a seat of a mobile terminal;
at least a part of a housing of the vehicle-mounted apparatus encloses a cavity;
the image generation unit is located in the cavity and is configured to generate a light beam; and
the light beam is propagated to object space outside the display device through the cavity and a panel in the vehicle-mounted apparatus, to generate a virtual image visible to human eyes.

21. The display device according to claim 20, wherein the display device further comprises an optical element, the optical element is disposed in the cavity, and the optical element is configured to process the light beam.

22. An audio device, wherein the audio device comprises a speaker and the vehicle-mounted apparatus according to any one of claims 1 to 18;
the audio device is mounted in a seat of a mobile terminal;
at least a part of a housing of the vehicle-mounted apparatus encloses a cavity; and
the speaker is located in the cavity and is configured to generate a sound wave.

23. A terminal, wherein the mobile terminal comprises the vehicle-mounted apparatus according to any one of claims 1 to 20, or comprises the display device according to claim 20 or 21, or comprises the audio device according to claim 22.
